# EUROPEAN PATENT SPECIFICATION

(11) **EP 1 190 122 B1**
(45) Date of publication and mention of the grant of the patent: **11.02.2004**
(21) Application number: 00927574.4
(22) Date of filing: 12.05.2000
(51) Int. Cl.: C30B 25/14, C30B 25/02

(54) **METHOD AND APPARATUS FOR EPITAXIALLY GROWING A MATERIAL ON A SUBSTRATE**
VERFAHREN UND VORRICHTUNG ZUM EPITAKTISCHEM WACHSEN EINES MATERIALS AUF EINEM SUBSTRAT
PROCEDE ET DISPOSITIF PERMETTANT DE GENERER UNE CROISSANCE EPITAXIALE D'UN MATERIAU SUR UN SUBSTRAT

(30) Priority: 13.05.1999 EP 99303738
(43) Date of publication of application: 27.03.2002
(73) Proprietor: EMF Ireland Limited, Glanmire, County Cork (IE)
(72) Inventor: ROBINSON, Michael Franks, Ely, Cambridgeshire CB6 3QE (GB)
(74) Representative: Skone James, Robert Edmund
(86) International application number: PCT/GB2000/001829
(87) International publication number: WO 2000/070129

(56) References cited:
- EP-A- 0 238 830
- EP-A- 0 505 251
- EP-A- 0 559 326
- EP-A- 0 683 249
- US-A- 4 137 108
- PATENT ABSTRACTS OF JAPAN vol. 007, no. 232 (C-190), 14 October 1983 (1983-10-14) & JP 58 125698 A (MATSUSHITA DENKI SANGYO KK), 26 July 1983 (1983-07-26) cited in the application
- PATENT ABSTRACTS OF JAPAN vol. 007, no. 259 (C-195), 18 November 1983 (1983-11-18) & JP 58 140391 A (MATSUSHITA DENKI SANGYO KK), 20 August 1983 (1983-08-20) cited in the application
- PATENT ABSTRACTS OF JAPAN vol. 17, no. 683 (E-1477), 15 December 1993 (1993-12-15) & JP 05 234908 A (NIPPON STEEL CORP), 10 September 1993 (1993-09-10)
- PATENT ABSTRACTS OF JAPAN vol. 016, no. 283 (C-0955), 24 June 1992 (1992-06-24) & JP 04 074858 A (ASAHI CHEM IND CO LTD), 10 March 1992 (1992-03-10) cited in the application
- PATENT ABSTRACTS OF JAPAN vol. 018, no. 161 (E-1526), 17 March 1994 (1994-03-17) & JP 05 335622 A (ASAHI CHEM IND CO LTD), 17 December 1993 (1993-12-17) cited in the application
- PATENT ABSTRACTS OF JAPAN vol. 018, no. 020 (E-1489), 13 January 1994 (1994-01-13) & JP 05 259158 A (HIKARI GIJUTSU KENKYU KAIHATSU KK), 8 October 1993 (1993-10-08)

## Description

The invention relates to a method and apparatus for epitaxially growing a material on a substrate.

Conventional methods typically use a metalorganic chemical vapour phase deposition (MOCVD) epitaxial reactor. In such a reactor, the precursors containing the elements which are to be grown are supplied to a substrate such as a wafer supported on a wafer carrier which is heated. Heat is conveyed to the precursors which crack or dissociate into nascent atoms which then combine on the surface of the substrate. In a typical example, trimethylgallium and ammonia, together with hydrogen, are supplied to the substrate to form a gallium nitride layer.

A problem with known reactors is that the precursors have cracking temperatures which are much higher than the ideal growth temperatures. For example, ammonia typically requires temperatures up to 1000°C or more to crack efficiently while the ideal growth temperature is in the order of 650°C.

The problem with conventional reactors is that the wafer carrier will maintain the substrate at a relatively constant temperature which typically will be chosen to be the ideal growth temperature, in this example 650°C. Group V precursors such as ammonia are only very inefficiently cracked at this temperature.

JP-58125698 and JP-58140391 disclose methods of growing InP on a substrate using gaseous mixtures of precursors and decomposition species. JP-04074858 and JP-05335622 disclose alternative high vacuum deposition processes in which the decomposition species are reacted in a precursor atmosphere. Here the problem is addressed by decomposing one precursor at a remote location and then mixing the decomposition species with the other precursors and their decomposition species prior to deposition. However, problems still remain due to the occurrence of undesirable reactions in the mixture which reduce the overall efficiency of the process.

EP-A-0683249 discloses apparatus for independently supplying cation and anion material gases to a substrate using a rotating substrate holder.

In accordance with one aspect of the present invention a method of epitaxially growing a material on a substrate comprises separately heating precursors, at least two of which have different decomposition temperatures, to their respective decomposition temperatures at or adjacent a region of the substrate to generate species which are supplied separately in a sequential manner to the region and which combine at the region.

In contrast to the known methods, we separately heat the precursors to their respective decomposition temperatures at or adjacent this region, the region constituting a growth region in which the species combine. In this way, each precursor can be heated to its most efficient decomposition (cracking) temperature, while carrying out this process adjacent to the region minimises the risk of nascent atoms recombining before reaching the substrate surface.

The species formed by the decomposition of the precursors are highly reactive and rapidly form more stable products. The probability of a species being involved in further reactions is a function of time and concentration. By decomposing the precursors in the vicinity of the growth region, the species formed are encouraged to combine at the growth region on the substrate, rather than forming undesirable reaction products. The decomposition of the precursors in close proximity to the growth region reduces the time period in which unfavourable reactions can occur.

Preferably the species from each precursor are supplied separately to the region in a sequential manner. The species may be supplied separately to the region by moving the substrate, to cause the movement of the region with respect to the locations at which decomposition of the precursors occurs. Typically, at least one of the precursors will be supplied separately to the region as a gas stream.

Preferably the species may be chosen from the Group III and Group V elements. Alternatively the Group IV elements may be used such as Silicon and Carbon.

In the preferred example, one of the precursors, preferably the one with the lowest decomposition temperature, is heated to its cracking temperature by heating the substrate. In this preferred example, another of the precursors is heated to its cracking temperature at a location adjacent the region. Thus, the substrate could be heated in the range 550-800°C, for example 650°C, while the other precursor is heated to its optimum cracking temperature either directly or in the presence of a catalyst. Typically this temperature is in the range 400-1800°C.

In accordance with a second aspect of the present invention, apparatus for epitaxially growing a material on a substrate comprises a chamber containing a substrate support, the chamber having a first inlet for supplying a first precursor and a second inlet, separate from the first inlet, for supplying a second precursor, the first and second precursors having different decomposition temperatures; first and second heating means for separately heating the first and second precursors to their respective decomposition temperatures at or adjacent a region of the substrate to generate species which are supplied separately to the region; and means to supply the species in a sequential manner to the region such that the species combine at the region, wherein the means for supplying the species sequentially further comprises means for causing relative movement between the substrate support and at least one of the inlets.

Preferably, the second inlet is formed in a supply conduit located adjacent to the substrate support. This provides a convenient way of bringing the second precursor close to the substrate.

The second inlet can take a variety of forms including for example a circular hole or the like but is preferably in the form of an elongate slot.

The second heating means is conveniently provided in or adjacent the slot although it could be spaced upstream of the slot.

The supply conduit will typically be made of a refractory material such as quartz, SiN or alumina while the second inlet preferably defines a jet aperture having a transverse dimension of for example 2mm.

Preferably, the second inlet defines an outlet direction for the precursor which is at an acute angle to the substrate support since this will create a venturi effect which will encourage other gases such as hydrogen supplied from a remote source to pass under the conduit.

The second heating means is typically in the form of a heating wire made for example of iron, nickel, aluminium, platinum or their alloys, and in particular Platinum-Rhodium. The wire will typically be coiled.

In most applications, it is desired to extend the epitaxial growth to a relatively large region of the substrate. This is most conveniently achieved by moving the region across the substrate, for example by providing means for causing relative movement between the substrate support and at least one of the inlets.

Furthermore, the invention is not limited to the provision of a single region upon a single substrate. For example, a plurality of supply conduits may be provided for supplying the same or different precursors to regions on the substrate, the conduits and substrate support being relatively movable to bring the conduits into alignment with different regions. The supply conduits may be arranged to supply precursors separately and sequentially to the region.

Some examples of methods and apparatus according to the invention will now be described with reference to the accompanying drawings, in which:-
Figure 1 is a schematic cross-section through the apparatus of a first example;
Figure 2 is an enlarged, -cross-section through part of the apparatus shown in Figure 1;

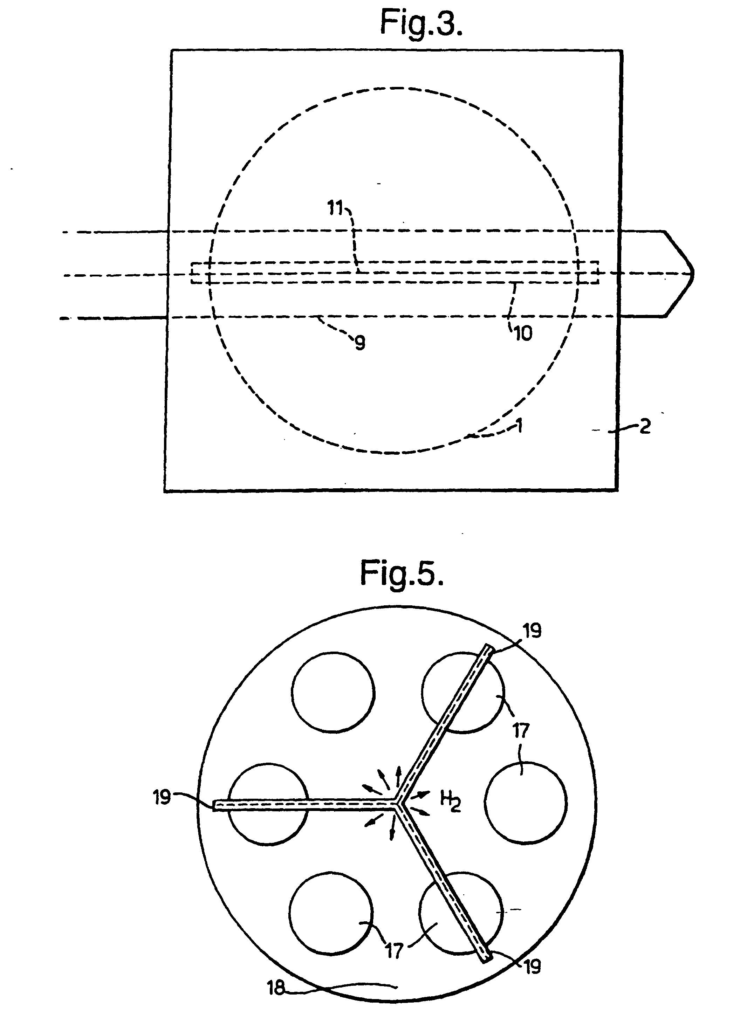

Figure 3 is an underneath plan of part of the apparatus shown in Figure 1;
Figure 4 is a schematic, cross-section through the apparatus of a second example;
Figure 5 is a schematic plan of a second example; and
Figure 6 is a schematic plan of a third example.

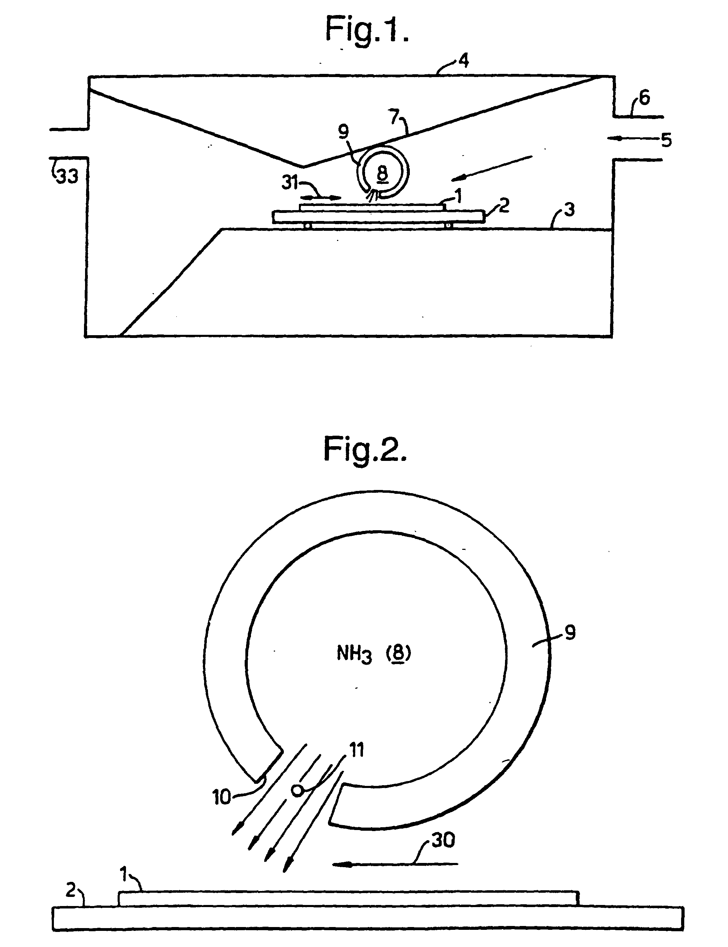

The reactor shown in Figure 1 comprises a reaction chamber 4 within which is provided a substrate carrier (susceptor) 3 which supports a substrate support (wafer carrier) 2. In Figure 1, a substrate (wafer) 1 is shown in place on the substrate support 2. The substrate carrier 3 may be a graphite block which is heated in a conventional manner by for example induction, infra-red or resistance heating methods.

A first inlet 6 is provided in a side wall of the reaction chamber 4 while a gas deflector 7 is mounted within the .reaction chamber to direct precursor gases 5, entering through the inlet 6, towards the wafer 1.

An injector conduit 9 extends transversely across the reaction chamber 4 and is in the form of a refractory tube of for example quartz having an elongate slot 10 forming a jetting aperture extending along its length above the wafer carrier 2 (see Figure 2).

A straight wire or coil 11 is supported within the slot 10 to form a heating element.

In use, a substrate 1 is placed on- the substrate support 2, the reaction chamber 4 is closed and then the pressure within the chamber adjusted as appropriate, typically in the range 0.7 ~ 130 kPa (5-1000 torr). Typically, the wafer material is chosen to promote epitaxial growth of the material and can include sapphire, GaN, GaAs, SiC or ZnO.

One or more reactive precursor gases 5 are introduced into the chamber through the inlet 6. Examples of the reactive gases include trimethylgallium (for Ga deposition), trimethylindium (for indium deposition) and so on depending upon the required composition of the deposited layer. Such a mixture may also contain precursors for semiconductor dopants. A gas such as hydrogen is also added to the mixture 5 to stabilise the radicals produced on dissociation of the precursor.

The substrate carrier 3 is heated such that the substrate 1 and the substrate support 2 are also heated due to their proximity to the substrate carrier 3 attaining a suitable growth temperature for the substrate 1 i.e. a temperature at which the precursor 5 introduced through the inlet 6 will most efficiently crack. A suitable temperature for the growth of GaN is in the range 600-800°C.

A second precursor gas 8, in this example ammonia, is supplied along the conduit 9 under pressure so that it exits through the jetting slot 10 past the heating wire 11. The wire 11 is heated to a temperature typically in the range 400-1800°C suitable for achieving optimum cracking of ammonia to generate N and H radicals. It will be noted in Figure 2 that the slot 10 is angled relative to a normal to the wafer 1 so as to cause gases introduced through the inlet 5 to be drawn under the conduit 9 as shown by an arrow 30 as a result of a venturi effect.

The precursor gas 5, upon reaching the substrate 1, will be cracked in a conventional manner and the resultant species, for example Ga atoms, will combine with nitrogen radicals from the gas 8 to initiate epitaxial growth of gallium nitride on the substrate 1.

The wire 11 is preferably made from a catalytic material such as a platinum-rhodium alloy and may be heated in the case of this alloy, to a temperature typically in the range 600-700°C. This can be achieved by electrical resistance heating if the element takes the form of a filament wire. The distance between the wire-11 and the substrate 1 is small to allow the maximum quantity of cracked product from the precursor 8 to react with the precursor mixture 5 at the substrate surface. This optimum distance is also influenced by the flow rate of the mixture 5, typical conditions for ammonia in the production of GaN being a distance of around 5mm for a flow velocity of 0.35ms⁻¹.

The jetting of the second precursor gas species on to the region of the substrate provides an advantage in that the jet acts as a gas shield which sweeps away any of the precursor gas 5 and its decomposition products that are not attached to the substrate. This allows the nitrogen and hydrogen radicals to reach the substrate surface in greater concentrations as they-are not mixed with the precursor gas 5 or its decomposition species before reaching it. This example therefore allows the species from each precursor to separately contact the surface of the substrate.

In order to control the area of growth, the substrate support 2 is movably mounted on the substrate carrier 3 and can be moved (by means not shown) in the directions indicated by an arrow 31 beneath the conduit 9. This movement allows the species from each precursor to separately reach the substrate surface sequentially, in any order, without mixing with the other precursor or its decomposition species.

This process can then be repeated to enable further layers to be laid down on the wafer so producing multilayered wafers containing materials of dissimilar dimensions, dopants or compositions.

Waste gases finally exit through an outlet 33.

An application for this invention is the production of microwave and optoelectronic devices. These devices are built up layer upon layer from different materials with different electrical properties. The configuration of these layers determines whether the device is for microwave or light emission i.e. a Field Effect Transistor or a Light Emitting Diode. To achieve optimum performance the layers have to be grown where possible at the most ideal temperature. This temperature will vary depending upon the material used and the device being fabricated. The advantage of this invention is that the growth temperature of the material is not compromised by the necessity to have a high temperature to crack the precursor materials such as ammonia. Advantageously the invention also provides the possibility of using precursors that would otherwise be incompatible in the gas phase such as dicyclopentadienylmagnesium, as these would otherwise form low vapour pressure adducts with group V species, for example from ammonia.

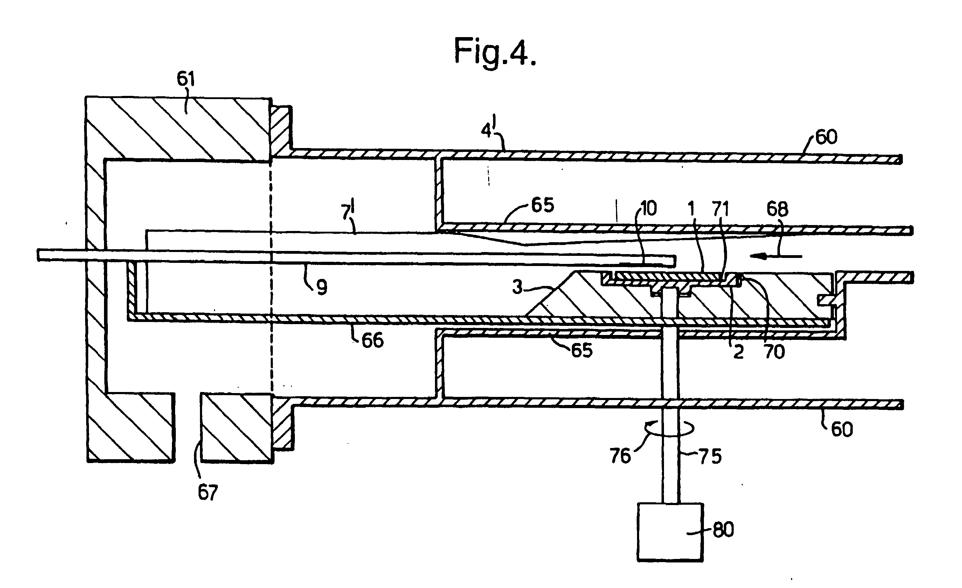

A second example of the present invention is shown in Figure 4. In this case the reaction chamber 4' comprises a tubular quartz outer cell 60 of substantially circular cross-section attached to a cell block end 61. Within the outer cell 60 is positioned an inner cell 65 of substantially square tubular section. A removable molybdenum carrier plate 66 is seated within inner cell 65. The carrier plate 66 extends along the base of the inner cell 65. The substrate carrier 3 equipped with heating means (not shown) rests upon the carrier plate 66. Additionally a self-supporting quartz gas deflector 7' is also positioned upon the carrier plate 66. An exit vent 67 for the gases is provided through the cell block end 61.

The injector conduit 9 enters the cell through the cell block end 61 and in contrast to the example shown in Figure 1, lies in a direction approximately parallel to that of the major gas flow (indicated by an arrow 68 in Figure 4) and extends only halfway across the substrate 1. The elongate slot 10 and heating element 11 are of appropriate dimensions to produce deposition in a region between the outer edge and centre of the substrate. In this case the substrate support 2 is positioned within a recess 70 provided in the substrate carrier 3. The substrate support itself also contains a recess 71 into which the substrate 1 is placed during deposition. The dimensions of both recesses and the substrate are such that the upper surfaces of the substrate 1 and substrate support 2 are substantially flush with that of the substrate carrier 3. The substrate support is mounted upon a shaft 75 which enters the cell from beneath and passes through holes in the substrate carrier 3, the carrier plate 66 and the cell walls 60, 65. The cell walls 60, 65 are equipped with suitable gas seals to maintain the cell leak tight. The lower end of the shaft is attached to a motor 80 or other suitable rotation means.

During operation both the outer and inner cells are evacuated in order to reduce the pressure differential across the inner cell walls 65. As in the previous example, one or more precursor gases enter the inner cell from an inlet on the right of the figure (not shown). Deposition of the material also occurs in a similar manner. However, here the rotation of shaft 75 by the motor (shown by arrow 76 in Figure 4) causes relative rotational rather than reciprocal motion with respect to the injector conduit.

In this example the injector conduit 9 and shaft 75 are detachable from the apparatus, allowing the slidable removal of the carrier plate 66, gas deflector 7' and substrate carrier assembly.

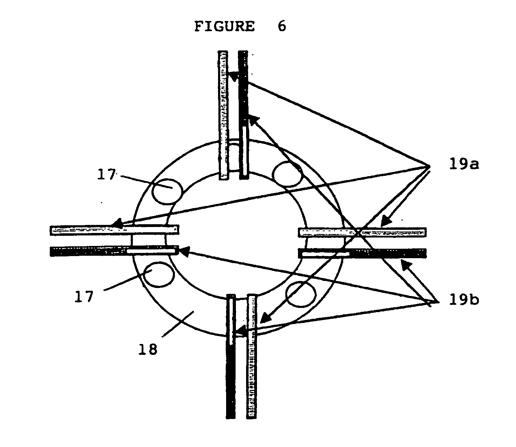

Figure 5 shows apparatus for growth of materials upon a plurality of substrates 17 mounted upon a heated susceptor 18 in a chamber (not shown). One or both of the conduits 19 and the susceptor 18 are rotatable. Layers of a semiconducting wafer may be deposited sequentially using a plurality of precursor supply conduits 19, similar to the conduit 9, radiating from the centre of the susceptor. In one example, the supply conduits are grouped as shown so as to bring precursors for both reacting species to a single region simultaneously. Substrates 17 are successively-brought into close proximity to supply conduits 19 by relative movement of the conduits 19 and substrates 17. In this example, hydrogen, nitrogen, argon, or another suitable sweep gas is introduced to the system at the centre of the substrate support, flowing radially outwards rather than being supplied directly with one of the precursors. This flow sweeps away the spent reaction products.

In alternative example shown in Figure 6, conduits 19a and 19b individually supply precursors sequentially to the growth region, a rapid relative movement between each substrate and each precursor conduit ensuring that only a short time elapses between the delivery of each species. The efficiency of the deposition process is therefore increased as in each case the species from the precursors are allowed to reach the substrate without reacting with species from other precursors or the precursors themselves.

The conduits 19a and 19b supply the precursors from around the periphery of an annular susceptor. The substrates are positioned circumferentially around the surface of the annular susceptor. It will be appreciated that one or more of the conduits could be equipped with means to decompose one or more of the precursors supplied.

In this example each of the conduits is equipped with heated wires to decompose the separate precursors at their respective temperatures, conduits 19a supplying the Group V precursor ammonia and conduits 19b supplying the Group III precursor trimethylgallium. The substrates 17 are also heated by similar methods to those in the previous examples, the heating ensuring the uniformity of the deposited materials.

This arrangement is particularly advantageous in that the apparatus can be scaled up to manufacture devices in large quantities without altering the gas flow on chemistry in the vicinity of each substrate. This may be achieved by increasing the radius of the annular susceptor 18 allowing more substrates to be positioned around its circumference, along with providing more conduits 19a and 19b as appropriate. In addition, substrates of different sizes may also be used.

Although not shown in Figure 6, a radial flow of hydrogen is also provided in this example. Alternatively other gases such as nitrogen or argon could be used.

## Claims

1. A method of epitaxially growing a material on a substrate (1), the method comprising separately heating precursors (5, 8), at least two of which have different decomposition temperatures, to their respective decomposition temperatures, at or adjacent a region of the substrate, to generate species which are supplied separately in a sequential manner to the region and which combine at the region.

2. A method according to claim 1 or claim 2, wherein the species are supplied separately to the region by the relative movement of the substrate to cause the movement of the region with respect to the locations at which decomposition of the precursors occurs.

3. A method according to any of the preceding claims, wherein at least one precursor is supplied separately to the region as a gas stream.

4. A method according to claim 3, wherein the gas stream is arranged so as to form a gas shield to sweep away precursors or decomposition products not attached to the substrate.

5. A method according to any of the preceding claims, wherein the species are chosen from the Group III and Group V elements.

6. A method according to any of claims 1 to 4, wherein the species are chosen from the Group IV elements.

7. A method according to claim 5, wherein the species comprise Gallium and Nitrogen.

8. A method according to claim 6, wherein the species comprise Carbon and Silicon.

9. A method according to claim 7, wherein one of the precursors is ammonia.

10. A method according to any of the preceding claims, wherein the substrate comprises a semiconductor such as Gallium-Arsenide.

11. A method according to any of the preceding claims, wherein the substrate comprises a semiconductor such as Silicon Carbide.

12. A method according to any of the preceding claims, wherein one of the precursors is heated to its decomposition temperature by heating the substrate.

13. A method according to claim 12, wherein the substrate is heated to the decomposition temperature of the precursor with the lower decomposition temperature.

14. A method according to claim 12 or claim 13, wherein the substrate is heated to a temperature in the range 550-800°C.

15. A method according to any of the preceding claims, wherein one of the precursors is heated to its decomposition temperature at a location adjacent the region.

16. A method according to claim 15, wherein the precursor is heated to a temperature in the range 400-1800°C.

17. A method according to any of the preceding claims, further comprising moving the region across the substrate.

18. Apparatus for epitaxially growing a material on a substrate (1), the apparatus comprising a chamber (4) containing a substrate support (2), the chamber having a first inlet (6) for supplying a first precursor (5) and a second inlet (9), separate from the first inlet, for supplying a second precursor (8), the first and second precursors having different decomposition temperatures; first and second heating means for separately heating the first and second precursors to their respective decomposition temperatures at or adjacent a region of the substrate to generate species which are supplied separately to the region; and means to supply the species in a sequential manner to the region such that the species combine at the region, wherein the means for supplying the species sequentially further comprises means for causing relative movement between the substrate support and at least one of the inlets.

19. Apparatus according to claim 18, wherein the second inlet is formed in a supply conduit located adjacent the substrate support.

20. Apparatus according to claim 19, wherein the second inlet is in the form of an elongate slot.

21. Apparatus according to claim 19 or claim 20, wherein the second heating means is provided in or adjacent the slot.

22. Apparatus according to any of claims 18 to 21, wherein the second heating means is in the form of a heating wire.

23. Apparatus according to claim 22, wherein the heating wire is formed from a catalyst material.

24. Apparatus according to any of claims 18 to 23, wherein the first heating means is located at a position to heat the substrate support.

25. Apparatus according to claim 18, wherein a plurality of supply conduits are provided for supplying the same or different precursors to regions on the substrate, the conduits and substrate support being relatively movable to bring the conduits into alignment with different regions.

26. Apparatus according to claim 18 wherein the means for supplying the species sequentially is adapted to cause relative movement between the substrate support and at least one of the inlets in a transverse manner.

27. Apparatus according to claim 18 wherein the means for supplying the species sequentially is adapted to cause relative movement between the substrate support and at least one of the inlets in a rotational manner.

## Patentansprüche

1. Verfahren zum epitaktischen Wachsen eines Materials auf einem Substrat (1), bei weichem Vorläufer (5, 8), von denen wenigstens zwei unterschiedliche Zerlegungstemperaturen aufweisen, getrennt auf ihre jeweilige Zerlegungstemperatur in einem Bereich des Substrates oder in der Nähe hiervon erhitzt werden, um Spezies zu erzeugen, die getrennt aufeinanderfolgend dem Bereich zugeführt werden und die in dem Bereich kombiniert werden.

2. Verfahren nach den Ansprüchen 1 oder 2, bei welchem die Spezies getrennt dem Bereich durch Relativbewegung des Substrates zugeführt werden, um eine Bewegung des Bereiches gegenüber jenen Stellen zu bewirken, an denen die Zerlegung der Vorläufer auftritt.

3. Verfahren nach einem der vorhergehenden Ansprüche, bei welchem wenigstens ein Vorläufer getrennt dem Bereich als Gasstrom zugeführt wird.

4. Verfahren nach Anspruch 3, bei welchem der Gasstrom so angeordnet wird, dass er eine Gasabschirmung bewirkt, um Vorläufer oder Zerlegungsprodukte abzuführen, die nicht an dem Substrat anhaften.

5. Verfahren nach einem der vorhergehenden Ansprüche, bei welchem die Spezies aus der Gruppe lll und der Gruppe V des periodischen Systems der Elemente ausgewählt sind.

6. Verfahren nach einem der Ansprüche 1 bis 4, bei welchem die Spezies aus der Gruppe IV der Elemente ausgewählt sind.

7. Verfahren nach Anspruch 5, bei welchem die Spezies Gallium und Stickstoff sind.

8. Verfahren nach Anspruch 6, bei welchem die Spezies Kohlenstoff und Silizium sind.

9. Verfahren nach Anspruch 7, bei welchem einer der Vorläufer Ammoniak ist.

10. Verfahren nach einem der vorhergehenden Ansprüche, bei welchem das Substrat ein Halbleiter, beispielsweise Gallium-Arsenid, ist.

11. Verfahren nach einem der vorhergehenden Ansprüche, bei welchem das Substrat ein Halbleiter, beispielsweise Silizium-Karbid, ist.

12. Verfahren nach einem der vorhergehenden Ansprüche, bei welchem einer der Vorläufer auf seine Zerlegungstemperatur durch Erhitzung des Substrats aufgeheizt wird.

13. Verfahren nach Anspruch 12, bei welchem das Substrat auf die Zerlegungstemperatur des Vorläufers mit der niedrigeren Zerlegungstemperatur aufgeheizt wird.

14. Verfahren nach Anspruch 12 oder 13, bei welcher das Substrat auf eine Temperatur zwischen 550 und 800°C aufgeheizt wird.

15. Verfahren nach einem der vorhergehenden Ansprüche, bei welchem einer der Vorläufer auf seine Zerlegungstemperatur an einer Stelle benachbart zu dem Bereich aufgeheizt wird.

16. Verfahren nach Anspruch 15, bei welchem der Vorläufer auf eine Temperatur im Bereich zwischen 400 und 1800°C aufgeheizt wird.

17. Verfahren nach einem der vorhergehenden Ansprüche, bei welchem der Bereich über dem Substrat bewegt wird.

18. Vorrichtung zum epitaktischen Wachsen eines Materials auf einem Substrat (1) mit einer Kammer (4), die einen Substratsockel (2) aufweist und einen ersten Einlass (6) besitzt, um einen ersten Vorläufer (5) zuzuführen, und die einen zweiten Einlass (9) besitzt, der von dem ersten Einlass getrennt ist und einen zweiten Vorläufer (8) zuführt, wobei erster und zweiter Vorläufer unterschiedliche Zerlegungstemperaturen aufweisen, wobei erste und zweite Heizeinrichtungen vorgesehen sind, um getrennt den ersten und zweiten Vorläufer auf ihre jeweilige Zerlegungstemperatur auf einem Bereich des Substrates oder in der Nähe hiervon aufzuheizen, um Spezies zu erzeugen, die getrennt dem Bereich zugeführt werden, und wobei Mittel vorgesehen sind, um die Spezies in Kombination dem Bereich zuzuführen, und wobei die Mittel zum aufeinanderfolgenden Zuführen der Spezies außerdem Mittel aufweisen, die eine Relativbewegung zwischen dem Substratsockel und wenigstens einem der Einlässe bewirken.

19. Vorrichtung nach Anspruch 18, bei welcher der zweite Einlass in einer Zuführungsleitung vorgesehen ist, die benachbart zum Substratsockel liegt.

20. Vorrichtung nach Anspruch 19, bei welcher der zweite Einlass die Gestalt eines langgestreckten Schlitzes hat.

21. Vorrichtung nach den Ansprüchen 19 oder 20, bei welcher die zweiten Heizmittel in dem Schlitz oder benachbart hierzu angeordnet ist.

22. Vorrichtung nach einem der Ansprüche 18 bis 21, bei welcher die zweiten Heizmittel die Gestalt eines Heizdrahtes haben.

23. Vorrichtung nach Anspruch 22, bei welcher der Heizdraht aus einem katalytischen Material besteht.

24. Vorrichtung nach einem der Ansprüche 18 bis 23, bei welcher die ersten Heizmittel an einer Stelle angeordnet sind, in der der Substratsockel aufgeheizt wird.

25. Vorrichtung nach Anspruch 18, bei welcher eine Vielzahl von Zuführungsleitungen vorgesehen ist, um gleiche oder unterschiedliche Vorläufer nach Bereichen des Substrates zuzuführen, wobei die Leitungen und der Substratsockel relativ zueinander beweglich sind, um die Leitungen auf unterschiedliche Bereiche auszurichten.

26. Vorrichtung nach Anspruch 18, bei welcher die Mittel zum aufeinanderfolgenden Zuführen der Spezies so ausgebildet sind, dass eine Relativbewegung zwischen dem Substratsockel und wenigstens einem der Einlässe in Querrichtung bewirkt wird.

27. Vorrichtung nach Anspruch 18, bei welcher die Mittel zur aufeinanderfolgenden Zuführung der Spezies derart ausgebildet sind, dass eine Relativbewegung zwischen dem Substratsockel und wenigstens einem der Einlässe in Drehrichtung bewirkt wird.

## Revendications

1. Procédé pour la croissance épitaxiale d'une matière sur un substrat (1), le procédé comprenant le chauffage séparé de précurseurs (5, 8), dont au moins deux ont des températures de décomposition différentes, à leur températures respectives de décomposition, à une région ou à proximité immédiate d'une région du substrat, afin de générer des espèces qui sont fournies séparément d'une manière séquentielle à la région et qui se combinent au niveau de la région.

2. Procédé selon la revendication 1 ou la revendication 2, dans lequel les espèces sont fournies séparément à la région par le mouvement relatif du substrat pour provoquer le mouvement de la région par rapport aux emplacements auxquels une décomposition des précurseurs a lieu.

3. Procédé selon l'une quelconque des revendications précédentes, dans lequel au moins un précurseur est fourni séparément à la région sous forme d'un courant de gaz.

4. Procédé selon la revendication 3, dans lequel le courant de gaz est agencé de façon à former un écran de gaz pour éliminer par balayage des précurseurs ou des produits de décomposition non attachés au substrat.

5. Procédé selon l'une quelconque des revendications précédentes, dans lequel les espèces sont choisies parmi des éléments des groupes III et V.

6. Procédé selon l'une quelconque des revendications 1 à 4, dans lequel les espèces sont choisies parmi des éléments du groupe IV.

7. Procédé selon la revendication 5, dans lequel les espèces comprennent du gallium et de l'azote.

8. Procédé selon la revendication 6, dans lequel les espèces comprennent du carbone et du silicium.

9. Procédé selon la revendication 7, dans lequel l'un des précurseurs est l'ammoniac.

10. Procédé selon l'une quelconque des revendications précédentes, dans lequel le substrat comprend un semicconducteur tel que de l'arsénure de gallium.

11. Procédé selon l'une quelconque des revendications précédentes, dans lequel le substrat comprend un semicconducteur tel que du carbure de silicium.

12. Procédé selon l'une quelconque des revendications précédentes, dans lequel un des précurseurs est chauffé à sa température de décomposition par chauffage du substrat.

13. Procédé selon la revendication 12, dans lequel le substrat est chauffé à la température de décomposition du précurseur ayant la température de décomposition plus basse.

14. Procédé selon la revendication 12 ou la revendication 13, dans lequel le substrat est chauffé à une température dans la plage de 550 à 800°C.

15. Procédé selon l'une quelconque des revendications précédentes, dans lequel l'un des précurseurs est chauffé à sa température de décomposition en un emplacement adjacent à la région.

16. Procédé selon la revendication 15, dans lequel le précurseur est chauffé à une température dans la plage de 400 à 1800°C.

17. Procédé selon l'une quelconque des revendications précédentes, comprenant en outre le déplacement de la région sur le substrat.

18. Appareil pour la croissance épitaxiale d'une matière sur un substrat (1), l'appareil comportant une chambre (4) contenant un support (2) de substart, la chambre ayant une première entrée (6) pour l'alimentation en un premier précurseur (5) et une seconde entrée (9), séparée de la première entrée, pour une alimentation en un second précurseur (8), les premier et second précurseurs ayant des températures de décomposition différentes ; des premier et second moyens chauffants destinés à chauffer séparément les premier et second précurseurs à leurs températures respectives de décomposition, à une région ou à proximité immédiate d'une région du substrat pour générer des espèces qui sont fournies séparément à la région ; et des moyens pour fournir les espèces d'une manière séquentielle à la région de façon que les espèces se combinenent au niveau de la région, les moyens de fourniture séquentielle des espèces comprenant en outre des moyens pour provoquer un mouvement relatif entre le support du substrat et au moins l'une des entrées.

19. Appareil selon la revendication 18, dans lequel la seconde entrée est formée par un conduit d'alimentation placé de façon à être adjacent au support de substrat.

20. Appareil selon la revendication 19, dans lequel la seconde entrée se présente sous la forme d'une fente allongée.

21. Appareil selon la revendication 19 ou la revendication 20, dans lequel le second moyen chauffant est prévu dans ou à proximité immédiate de la fente.

22. Appareil selon l'une quelconque des revendications 18 à 21, dans lequel le second moyen chauffant se présente sous la forme d'un fil chauffant.

23. Appareil selon la revendication 22, dans lequel le fil chauffant est formé d'une matière du type catalyseur.

24. Appareil selon l'une quelconque des revendications 18 à 23, dans lequel le premier moyen chauffant est placé dans une position pour chauffer le support du substrat.

25. Appareil selon la revendication 18, dans lequel plusieurs conduits de support sont prévus pour amener les mêmes précurseurs ou des précurseurs différents à des régions sur le substrat, les conduits et le support du substrat étant relativement mobiles pour amener les conduits en alignement avec différentes régions.

26. Appareil selon la revendication 18, dans lequel les moyens pour la fourniture séquentielle des espèces sont conçus pour provoquer un mouvement relatif entre le support de substrat et au moins l'une des entrées, d'une manière transversale.

27. Appareil selon la revendication 18, dans lequel les moyens pour la fourniture séquentielle des espèces sont conçus pour provoquer un mouvement relatif de rotation entre le support du substrat et au moins l'une des entrées.
